# FASCICULE DE BREVET EUROPEEN

(11) **EP 0 369 842 B1**
(45) Date de publication et mention de la délivrance du brevet: **10.04.1996**
(21) Numéro de dépôt: 89402912.3
(22) Date de dépôt: 23.10.1989
(51) Int. Cl.: H01L 27/115, H01L 23/528

(54) **Procédé d'obtention d'un circuit integré à haute densité d'intégration tel que mémoire EPROM**
Verfahren zur Herstellung eines hochintegrierten Schaltkreises, z.B. eines EPROMs
Method for the production of a large-scale integrated circuit such as an EPROM

(30) Priorité: 25.10.1988 FR 8813934
(43) Date de publication de la demande: 23.05.1990
(73) Titulaire: COMMISSARIAT A L'ENERGIE ATOMIQUE, F-75015 Paris Cédex 15 (FR)
(72) Inventeur: Hartmann, Joel, F-38640 Claix (FR)
(74) Mandataire: Signore, Robert

(56) Documents cités:
- EP-A- 0 024 735
- EP-A- 0 182 198
- EP-A- 0 183 517
- DE-A- 3 542 939
- GB-A- 2 156 586

## Description

L'invention a pour objet un procédé d'obtention d'un circuit intégré présentant une haute densité d'intégration, et notamment une mémoire EPROM, et un circuit obtenu grâce à ce procédé.

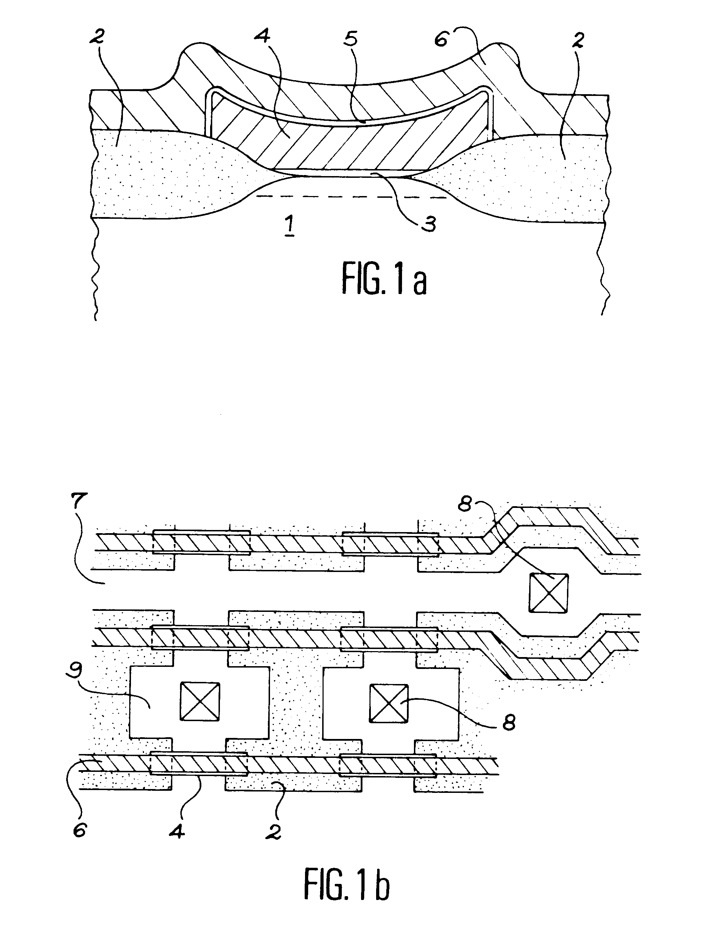

Le début d'un procédé d'obtention typique de mémoire EPROM conduit au produit représenté figure la en coupe et figure 1b en vue de dessus. On fait croître par oxydation thermique des zones isolantes d'oxyde de champ 2 sur la surface supérieure d'un substrat en silicium 1, selon le procédé LOCOS. Les zones isolantes 2 ont une épaisseur variable qui s'amenuise à leurs extrémités et croissent aussi bien vers l'intérieur que vers l'extérieur du substrat 1, si bien que la face supérieure du substrat 1 perd sa planéité, les parties entre les zones isolantes 2 étant en creux. On forme ensuite successivement une couche d'oxyde isolante inférieure 3 par exemple par croissance thermique du substrat et une couche conductrice de silicium polycristallin pour constituer les grilles flottantes. Après quoi on effectue une gravure de cette dernière couche par des techniques de photolithographie de façon à réaliser des ouvertures dans cette couche, au-dessus des zones isolantes 2. Une couche d'oxyde intermédiaire isolante 5 est ensuite déposée au-dessus de la couche gravée 4 de silicium polycristallin et sur ses flancs, puis une seconde couche de silicium polycristallin 6, destinée à composer les grilles de commande, est déposée sur l'ensemble.

Les étapes suivantes consistent à graver par des techniques de photolithographie l'ensemble formé par les couches 6, 5 et 4 suivant des bandes parallèles au plan de coupe de la figure 1a jusqu'à arriver à la couche 3. Les régions de sources 7 et de drains 9 sont établies aux endroits gravés. Puis une couche d'oxyde supérieure est déposée et soumise à un fluage thermique puis à une gravure par des techniques de photolithographie pour réaliser des ouvertures de contact 8 sur les sources et les drains (la couche 3 étant attaquée au cours de cette gravure). Les lignes de connexions aux sources et aux drains (lignes d'alimentation et lignes d'éléments binaires) sont alors installées sur la couche d'oxyde supérieure. Comme la couche d'oxyde supérieure est déposée sur une surface tourmentée, elle ne peut donc pas non plus comporter une surface supérieure plane, même après le fluage, ce qui complique l'installation des lignes de connexions électriques et la rend très difficile si les accidents de relief sont trop nombreux, c'est-à-dire si les points mémoire de la mémoire sont trop rapprochés. Par ailleurs, la photolithographie ne peut être réalisée avec un alignement parfait ; il faut donc tenir compte des défauts d'alignement ou des centrages en accroissant la distance entre les zones d'ouverture de contact 8 et les couches conductrices 4 et 6 environnantes, ou, en d'autres termes, en espaçant les bandes des grilles de commande, en les déviant localement (comme représenté figure 1b) pour les faire passer à distance des zones d'ouverture de contact 8, ou en les rétrécissant à ces endroits. Les documents DE-A1-35 42 939, EP-A2-0 182 198 et EP-A2-0 024 735 font partie de cet art antérieur. Il résulte de telles dispositions que la densité d'intégration de points de mémoire est plutôt faible (les deuxième et troisième documents indiquent comme exemple, respectivement, des surfaces de 25 µm et 18,5x13,5 µm pour chaque point de mémoire.

Le brevet américain 4 597 060 décrit un autre type de mémoire EPROM dans lequel on réduit notablement le nombre de lignes de connexions électriques au sommet du circuit compte tenu du fait que les lignes d'éléments binaires coïncident avec les drains et les lignes d'alimentation avec les sources. Dans cette conception, il n'y a pas de zones isolantes d'oxyde de champ sur le substrat : toute la surface de chaque grille flottante est au-dessus de parties conductrices du substrat. Il en résulte que le rapport de la capacité entre grilles flottantes et de commande et de la capacité totale d'un point mémoire est plus faible pour une surface d'interface entre grille flottante et grille de commande donnée, ce qui est nuisible pour les propriétés de programmation de la mémoire. Par ailleurs, du fait que chaque drain est en contact avec deux rangées de points de mémoire, les courants de fuite sont plus importants.

L'invention a pour objet un circuit qui évite ces inconvénients et offre une haute densité d'intégration c'est-à-dire, dans le cas d'une mémoire EPROM, une haute densité de points de mémoire, par exemple une mémoire 16 Mbits. Ceci est réalisé par un procédé nouveau qui garantit que les ouvertures de contact des régions de sources et de drains sont situées exactement au centre d'élargissements ménagés dans les grilles de commande car elles sont auto-alignées par rapport à ces grilles de commande, qu'il est donc possible de rapprocher beaucoup plus que dans l'art antérieur en réduisant les distances de garde autour des ouvertures de contact. Le rapprochement des grilles de commande améliore par ailleurs la planéité de la couche d'isolant supérieure. Une réalisation favorite, dans laquelle on dépose la couche conductrice destinée à former les grilles de commande sur une surface sensiblement plane, permet d'arriver à une topographie encore plus favorable pour une haute densité d'intégration, car les lignes de connexion électrique sont établies sur une surface beaucoup plus plane.

Le procédé conforme à l'invention est défini par les revendications 1 à 8. Il conduit à la formation d'un circuit intégré qui comprend plus exactement au moins :
- un substrat comprenant des régions de sources et de drains et des zones isolantes séparées par des canaux,
- des bandes conductrices de grilles de commande situées au-dessus des canaux mais isolées de ceux-ci,
- un matériau isolant entre les bandes conductrices et sur lesdites bandes,
- des lignes de connexions électriques sur la couche isolante supérieure,
- des ouvertures de contact pour joindre les lignes de connexions à au moins certaines zones de sources et de drains et s'étendant dans le matériau isolant,
   où encore :
- le matériau isolant comprend un matériau isolant dans des intervalles entre les bandes conductrices et une couche isolante supérieure sur les bandes conductrices, et
- les bandes conductrices présentent des parties en retrait délimitant des élargissements des intervalles, les ouvertures de contact s'étendent au centre des élargissements et ont un contour situé à une distance invariable des bandes conductrices.

Le brevet EP-A-0 182 198 déjà cité montre un circuit intégré ayant sensiblement la même allure extérieure et en particulier des ouvertures de contact sensiblement au centre d'élargissements, mais avec un procédé pas spécifié qui ne donne pas la même densité d'intégration.

On entend par bande une piste rectiligne ou non linéaire mais continue. Ces parties en retrait correspondent favorablement à des rétrécissements locaux (à largeur réduite) des bandes conductrices rectilignes.

Ce circuit peut encore comprendre des zones conductrices de grilles flottantes disposées entre les canaux et les bandes conductrices, les zones conductrices étant séparées par les intervalles, isolées entre elles et isolées des canaux et des bandes conductrices.

Les ouvertures de contact des sources s'étendent dans des élargissements situés de façon avantageuse en quinconce par rapport aux élargissements dans lesquels s'étendent les ouvertures de contact des drains. Cette disposition accroît la densité d'intégration du circuit.

Généralement, les sources sont continues et communes entre deux bandes conductrices tandis que les drains disposés entre deux bandes conductrices sont discontinus et isolés par les zones isolantes. Les élargissements permettant de joindre les lignes d'alimentation aux sources sont situés périodiquement au- dessus d'une source choisie parmi un ensemble de sources communes et de façon avantageuse, comme on l'a vu précédemment, en quinconce par rapport aux élargissements permettant de relier les lignes d'éléments binaires aux drains.

Une opération de gravure anisotrope est mentionnée par exemple, dans un contexte différent, dans le brevet GB-A-2 156 586.

On évite donc de recourir à la photolithographie, impuissante à réaliser un positionnement précis des ouvertures de contact.

Selon un mode de réalisation, les zones isolantes étant établies sous forme de bandes, lesdites zones sont gravées après l'étape de gravure des intervalles, jusqu'à mettre à nu les régions du substrat situées dans les intervalles où vont être créées les sources, la couche isolante inférieure étant gravée au cours de cette gravure.

Cette gravure est effectuée de manière auto-alignée par rapport aux bandes conductrices.

Le procédé peut encore comprendre les étapes suivantes avant le dépôt de la couche conductrice :
- dépôt d'une couche conductrice inférieure sur la couche isolante inférieure,
- gravure de la couche conductrice inférieure selon des zones de gravure au-dessus des zones isolantes,
- création d'une couche isolante intermédiaire au-dessus de la couche conductrice inférieure gravée, la couche conductrice inférieure et la couche isolante intermédiaire étant ensuite gravées en même temps que la couche conductrice supérieure et la couche isolante supérieure, lors de l'étape de gravure des intervalles.

Avantageusement, la couche isolante intermédiaire est créée par trois étapes : de dépôt d'une première couche isolante intermédiaire, de gravure partielle de la première couche isolante intermédiaire pour ne la laisser subsister que dans les zones de gravure de la couche conductrice inférieure, et de dépôt d'une seconde couche isolante intermédiaire. C'est cette disposition qui améliore la planéité du circuit.

Les zones isolantes sont formées de préférence par oxydation thermique localisée du substrat. Dans ce cas, ces zones isolantes peuvent avantageusement être planarisées. Par ailleurs, l'installation des lignes de connexions peut s'effectuer par dépôt de métal suivi d'une gravure de ce dépôt.

On va maintenant passer à la description des figures suivantes annexées à titre illustratif et nullement limitatif pour une explication plus détaillée de l'invention :
- les figures 1a et 1b, déjà décrites, sont des vues partielles d'un circuit intégré de type EPROM conforme à l'art antérieur,
- la figure 2 est une vue de dessus partielle d'un circuit intégré du type EPROM conforme à l'invention,
- la figure 3 est une vue en perspective d'une partie élémentaire du circuit intégré de la figure 2 présentant deux coupes,
- les figures 4 et 5 sont deux coupes supplémentaires suivant les lignes IV-IV et V-V de la figure 3,
- la figure 6 représente une vue, analogue à la figure 3, d'une partie élémentaire d'un autre circuit intégré conforme à l'invention,
- les figures 7 à 14 détaillent certaines étapes du procédé de fabrication de circuits intégrés de type EPROM de l'invention.

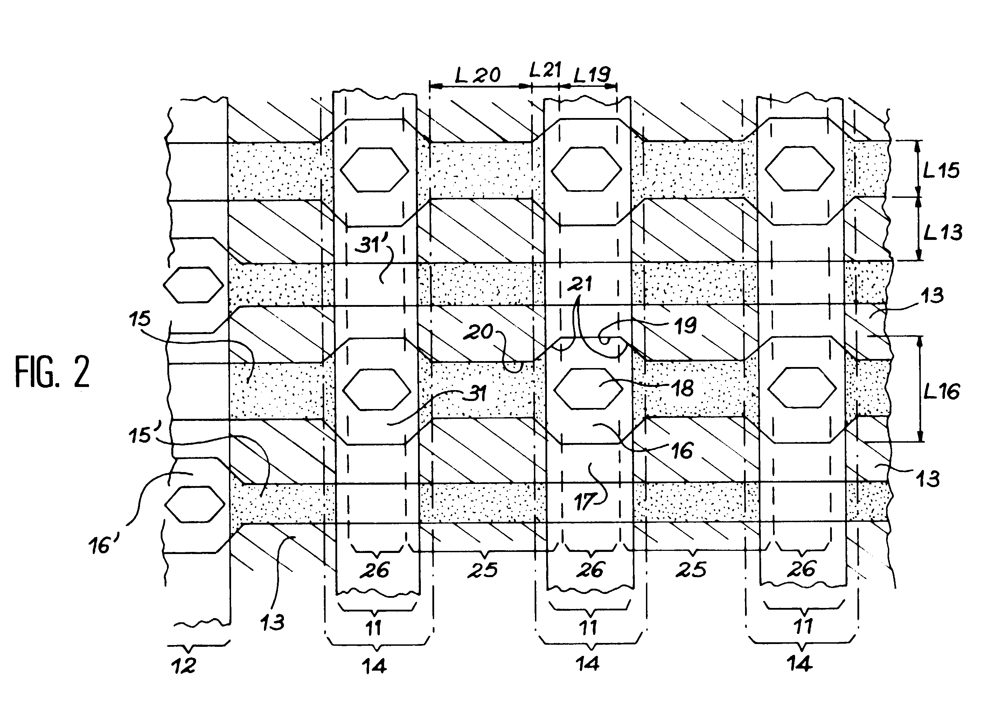

La figure 2 représente la disposition générale d'une mémoire EPROM conforme à l'invention. Les lignes de connexions électriques d'éléments binaires et d'alimentation 11 et 12 parallèles s'étendent sur sa surface supérieure. Sous ces lignes s'étendent, perpendiculaires à elles et séparées d'elles par un isolant, des bandes conductrices formant les grilles de commande et référencées par 13.

Des zones conductrices 14 correspondant aux grilles flottantes sont situées sous les bandes des grilles de commande 13 et partiellement sous les lignes d'éléments binaires 11 et au-dessus des zones de canal 26, alors que les lignes d'alimentation 12 s'étendent entre les zones conductrices 14.

Des intervalles isolants 15, 15′ séparent les bandes conductrices 13. Ils sont entièrement remplis de matériau isolant sauf dans des élargissements 16, 16′ qui y sont disposés à intervalles réguliers et correspondent à des parties en retrait 17 se faisant face de deux bandes conductrices 13 voisines. Les élargissements 16, 16′ sont remplis d'isolant à leur périphérie, c'est-à-dire au contact des bandes conductrices 13 et des zones conductrices 14, et remplis en leur centre de matériau conducteur 18 joignant les lignes de connexions 11 et 12 aux régions de drains et de sources du substrat. Les intervalles 15 surmontent les régions de drains du substrat et sont alternés avec les intervalles 15′ qui surmontent les régions de sources du substrat. Comme représenté figure 2, généralement les sources situées entre deux grilles de commande sont continues tandis que les drains sont séparés par des zones 25 d'isolant. De ce fait, il suffit d'avoir un élargissement 16′ au-dessus d'une région source périodiquement dans un intervalle 15′ et non systématiquement à chaque point mémoire. Par ailleurs, pour augmenter la densité d'intégration chaque élargissement 16′ est disposé de préférence en quinconce par rapport aux élargissements 16.

Dans la réalisation représentée, les parties en retrait 17 des bandes conductrices 13 sont délimitées par les bords des bandes conductrices 13 et plus précisément par un segment interne 19, parallèle au segment externe 20 qui constitue la limite des intervalles 15, 15′ hors des élargissements 16, 16′ et par deux segments de raccordement 21 joignant le segment interne 19 au segment externe 20.

La largeur L15 des intervalles 15, 15′ est par exemple de 0,6 µm sauf aux élargissements 16, 16′ où elle est L16=1,4 µm ; la largeur maximale L13 des bandes conductrices 13 est de 1,0 µm ; la longueur L19 des segments internes 19 est de 0,6 µm, celle L20 des segments externes 20 est de 0,8 µm et la distance L21 entre segments externes 20 et segments internes 19 est de 0,3 µm. Les parties en retrait 17 correspondent à des rétrécissements des bandes conductrices 13 à une largeur de 0,6 µm. On obtient donc un circuit intégré où un point de mémoire tient sur un rectangle de 2 µm de longueur et 1,6 µm de largeur, ce qui constitue un progrès sensible par rapport à l'art antérieur, où la surface des points de mémoire ne descend pas au-dessous de 8 à 10 µm. Il faut remarquer que les figures 1b et 2 ne sont pas à la même échelle et que les bandes de la grille de commande (6 et 14) ont à peu prés la même largeur dans les deux cas mais sont beaucoup plus rapprochées dans l'invention. On constate en effet que, grâce au procédé qui va être ensuite décrit, les zones de matériau conducteur 18 de raccordement entre les lignes de connexion 11 et 12 et les régions de sources et de drain sont parfaitement au centre des élargissements 16 et 16′, et même que leur contour (ici hexagonal) est situé à une distance invariable des segments internes 19 et de raccordement 21 qui constituent le bord de l'élargissement 16 ou 16′ dans lequel ce contour se trouve. En d'autres termes, on a réalisé l'auto-alignement des zones de contact dans les élargissements 16 et 16′.

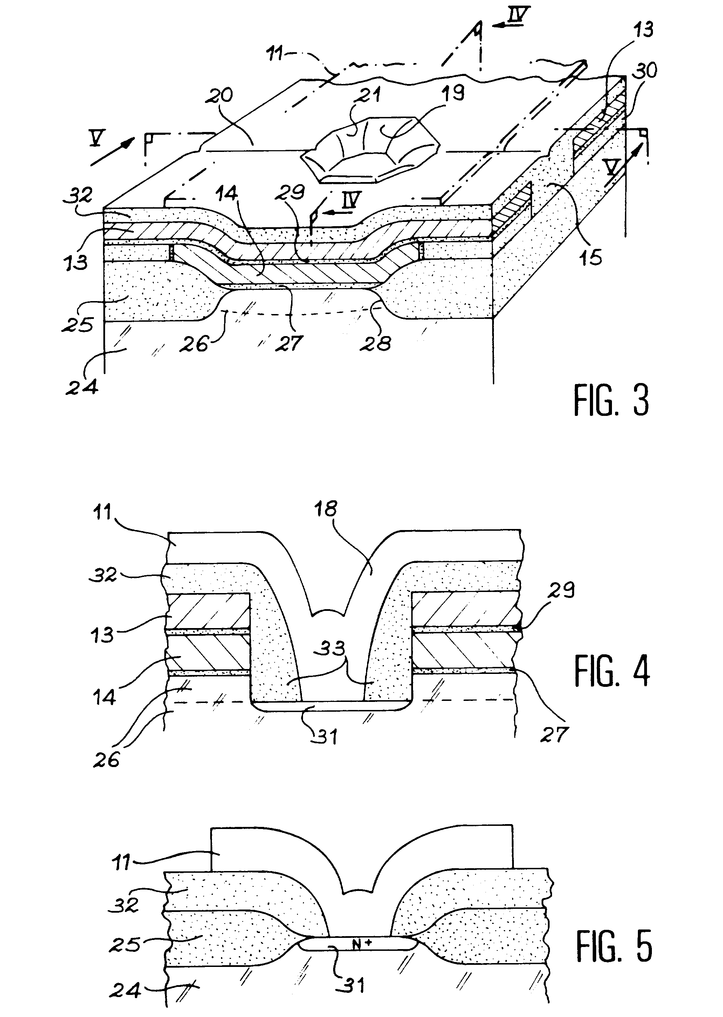

Les figures 3 à 5 donnent une représentation plus précise du circuit intégré avec un élargissement au-dessus d'une zone de drains. On reconnaît les éléments déjà énumérés, ainsi que le substrat 24, qui porte à sa partie supérieure des bandes isolantes 25 parallèles aux lignes de connexions 11 et 12 et périodiquement interrompues par les intervalles 15′ ; les canaux conducteurs 26 sont de part et d'autre des bandes isolantes 25 d'oxyde de champ et au-dessous des zones conductrices 14 des grilles flottantes. Des couches isolantes inférieures 27 séparent les canaux 26 des zones conductrices 14, et les zones conductrices 14 s'étendent latéralement un peu au-dessus des bords amincis 28 des bandes isolantes 25.

Des couches isolantes intermédiaires 29 séparent les zones conductrices 14 des bandes conductrices 13. Des blocs isolants 30 peuvent avantageusement être réalisés entre les bandes isolantes 25 et les bandes conductrices 13 en hauteur afin d'améliorer la planéité de l'ensemble, entre les intervalles 15 et 15′ en longueur et entre les zones conductrices 14 en largeur. Les régions de sources 31′ s'étendent dans le substrat 24, sous forme de bandes à l'emplacement des intervalles 15′ tandis que les régions de drains 31 sont localisées aux élargissements 16 des intervalles 15. Enfin, une couche supérieure d'oxyde 32 recouvre les bandes conductrices 13 et se raccorde à des flancs d'isolant 33 qui remplissent la partie périphérique des élargissements 16, 16′ et la totalité des intervalles 15, 15′.

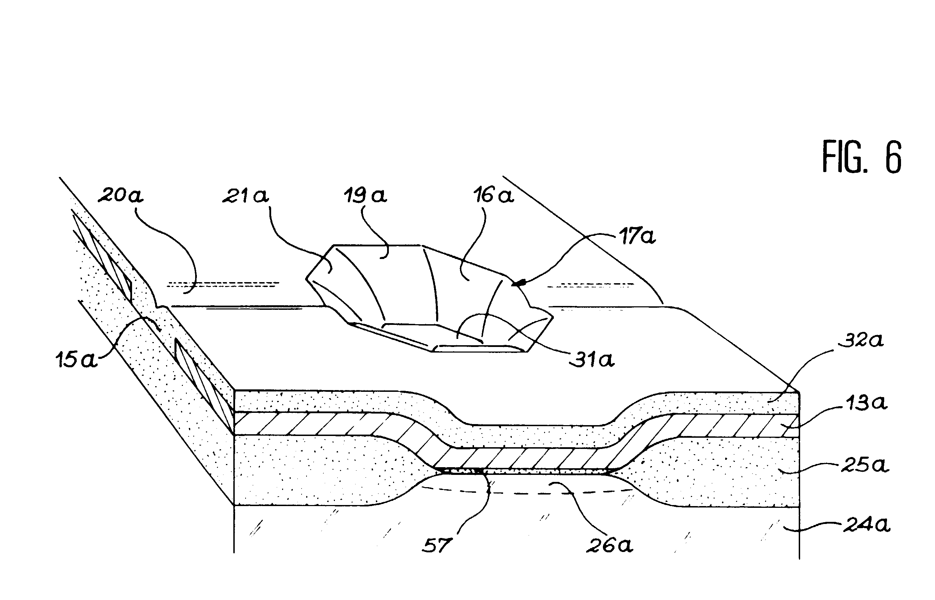

La figure 6 représente un autre type de circuit intégré conforme à l'invention et qui diffère du précédent en ce qu'il est dépourvu de grilles flottantes. Les éléments semblables ou analogues à ceux du circuit précédent portent le même numéro de référence auquel est adjoint l'indice a. On retrouve un substrat 24a comportant des bandes isolantes 25a, des canaux 26a, des régions de sources (non représentées) ou de drains 31a, des bandes conductrices 13a parallèles aux régions de sources ou de drains 31a, délimitées par des segments externes 20a, internes 19a et de raccordement 21a, et séparées par des intervalles 15a au-dessus des régions de drains 31a ou de sources. Ces intervalles présentent encore des élargissements 16a entre les parties en retrait 17a des bandes conductrices 13a. Une couche d'oxyde supérieure 32a recouvre les bandes conductrices 13a, comble les intervalles entre les élargissements ainsi que la partie périphérique des élargissements. Des lignes de connexions électriques s'étendent sur la couche d'oxyde supérieure 32a et dans les élargissements. Par contre, les bandes conductrices 13a ne sont séparées des canaux 26a que par des zones isolantes de recouvrement du substrat 57.

On va maintenant détailler plus précisément le procédé d'obtention d'un tel circuit intégré.

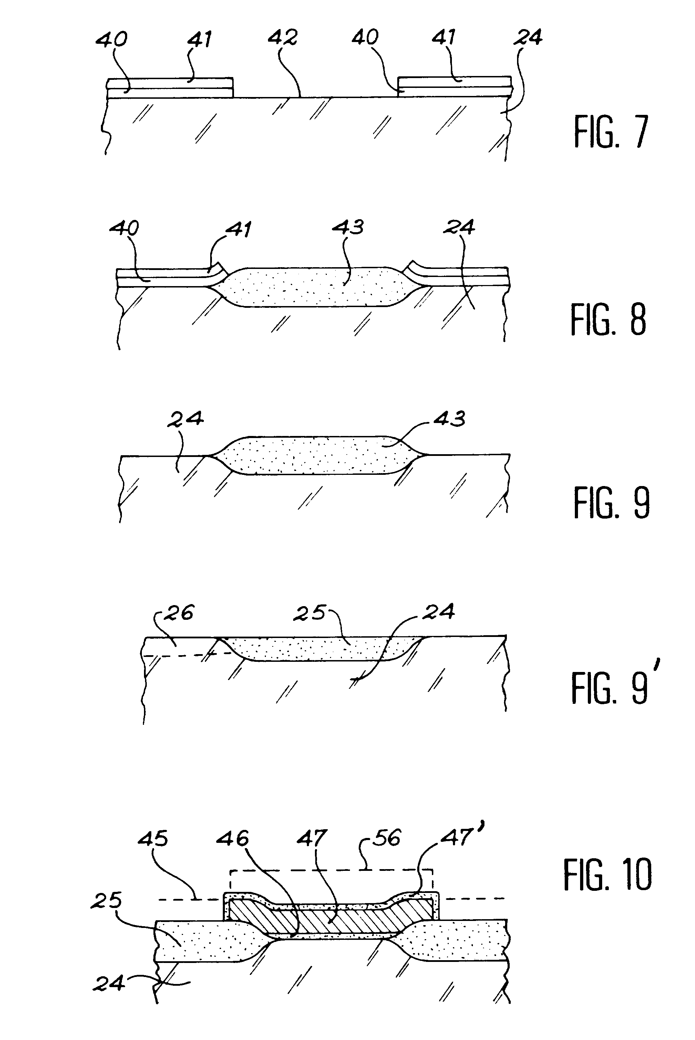

On commence par réaliser les bandes isolantes 25 d'oxyde de champ. Pour cela on dépose sur la surface supérieure plane du substrat 24, qui est ici en silicium de type p, un masque formé par exemple de bandes de bicouches (figure 7) : une couche d'oxyde de silicium 40 surmontée d'une couche de nitrure de silicium 41 épaisses respectivement de 10 et 100 nanomètres. Le substrat est soumis à une oxydation thermique qui crée des bourrelets d'oxyde de silicium 43 à l'emplacement des zones non masquées 42 (figure 8). L'oxydation est arrêtée quand l'épaisseur des bourrelets 43 atteint 700 nanomètres au centre. On élimine ensuite les couches 40 et 41 par attaque chimique. Pour obtenir une structure plane, on peut araser partiellement par une technique de planarisation (par exemple couchage d'une résine puis gravure plasma avec vitesse de gravure identique de l'oxyde et de la résine) les parties dépassant de la surface supérieure du substrat 24. On obtient finalement l'objet représenté figure 9, ou figure 9' si on effectue la planarisation pour que la face supérieure du substrat 24 soit parfaitement plane, où alternent les emplacements de canaux 26 formés dans le substrat conducteur et les bandes isolantes 25 d'oxyde de champ présentant une partie centrale d'épaisseur à peu près uniforme et des parties latérales extrêmes s'amincissant progressivement vers les emplacements de canaux 26. La suite de la description est donnée à partir de l'objet obtenu figure 9.

Une couche mince d'oxyde de silicium 46 constituant l'oxyde de grille, puis une couche conductrice de silicium polycristallin dopé N 45 et épaisse de 200 à 300 nanomètres sont ensuite formées sur la surface supérieure du substrat 24 (figure 10). La couche 46 est obtenue par oxydation thermique du substrat entre les bandes isolantes 25. Le dépôt de la couche conductrice 45 est réalisé en phase vapeur par voie chimique et à basse pression à 615°C. Il est suivi d'un dopage au phosphore au four à 900°C sous une atmosphère de POCl₃. Des ions de bore ont éventuellement été implantés dans les emplacements de canaux 26 pour ajuster le seuil de la cellule après la croissance de l'oxyde de grille 46. Un masque de résine 56 destiné à former les bandes conductrices 47 est déposé et aligné par rapport aux bandes isolantes 25. Une gravure par plasma réactif anisotrope est ensuite entreprise pour enlever la couche 45 ailleurs que sous le masque 56, après quoi une attaque chimique détruit le masque 56 à son tour. Ne subsistent finalement que des bandes conductrices 47 qui surmontent les emplacements de canaux 26, les bandes inférieures d'isolant 46 et les extrémités latérales des bandes d'oxyde de champ 25. On effectue ensuite une oxydation thermique des bandes conductrices 47, de façon à les protéger par une couche isolante 47′.

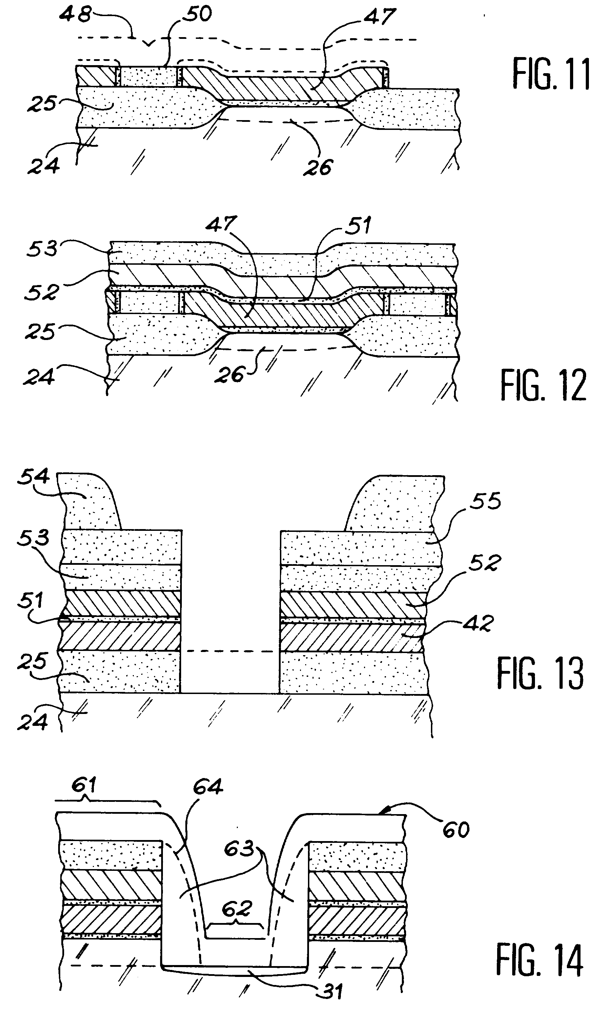

L'étape suivante, illustrée figure 11, consiste à déposer une couche isolante pour pouvoir installer la grille de commande. On réalise donc un dépôt d'oxyde 48 qui recouvre les bandes conductrices 47 et comble les intervalles situés entre elles. Il en résulte que sa surface supérieure n'est pas plane sauf dans les intervalles entre les bandes conductrices. Le dépôt d'oxyde est ensuite gravé par gravure plasma anisotrope jusqu'à mettre à nu la surface supérieure des bandes conductrices 47. La surface supérieure 50 de l'isolant est alors plane et prolonge la surface supérieure des bandes conductrices 47.

Les étapes subséquentes consistent, comme le représente la figure 12, à créer sur les bandes conductrices 47 une couche isolante 51, qui est par exemple une triple couche de dioxyde de silicium, de nitrure de silicium et de nouveau de dioxyde de silicium obtenues par oxydation et nitruration thermiques, puis une seconde couche conductrice 52 en silicium polycristallin dopé N, épaisse de 300 nanomètres, qui doit former les grilles de commande, et enfin une couche supérieure d'oxyde 53 épaisse de 300 à 500 nanomètres. La seconde couche conductrice 52 est déposée dans les mêmes conditions que la première couche conductrice 45. La couche superieure d'oxyde 53 est déposée chimiquement en phase vapeur par décomposition de tétraéthoxysilane. Un masque de résine 55 est déposé sur l'ensemble de façon à graver à l'aplomb de ce masque les couches 53, 52, 51 et 47 suivant des bandes parallèles au plan de la figure 12.

Ensuite (figure 13, en coupe perpendiculaire au plan de la figure 12), on recouvre le masque 55 d'un masque supérieur de résine 54 de composition différente qui ne dégage que l'emplacement des intervalles 15' et des élargissements 16' (zone de sources). Une gravure des parties du circuit qui ne sont pas recouvertes par le masque supérieur de résine 54 est effectuée jusqu'à atteindre le substrat 24 de manière à éliminer les bandes d'oxyde de champ 25 à cet endroit ainsi que la couche 46. Les bandes conductrices 13 ou lignes de mots, les zones conductrices 14 qui forment les points de mémoire et les blocs d'isolants intermédiaires 30 ont alors été formés. Les masques de résine 54 et 55 sont éliminés.

On réalise ensuite les régions de sources ou de drains 31 dans le substrat 24 par implantation d'ions d'arsenic au fond des intervalles 15' et des élargissements 16 et 16'. Les régions de sources ou de drains 31 sont parfaitement alignées par rapport aux grilles.

Un dépôt épais d'oxyde de 1000 à 1200 nanomètres est ensuite effectué. Ce dépôt porte la référence 60 sur la figure 14, et on peut y distinguer des parties supérieures 61 qui recouvrent les couches supérieures d'oxyde 53, des parties inférieures 62 qui recouvrent une partie des régions de sources ou de drains 31 situées au centre des élargissements 16, 16' et des flancs 63 raccordant les parties inférieures et supérieures 62 et 61 dans les élargissements 16, 16' tout en comblant entièrement les intervalles 15, 15' en dehors des élargissements 16, 16′. Un oxyde convenable pour le dépôt 60 peut être du tétraéthoxysilane ou du dioxyde de silicium dopé au phosphore ou au bore et phosphore.

Le dépôt d'oxyde 60 est ensuite attaqué par une gravure plasma anisotrope, jusqu'à éliminer entièrement les parties inférieures 62 dans les élargissements 16 et 16′ pour mettre les régions de sources et de drains 31 à nu. Les parties supérieures 61 sont également, en principe, enlevées, mais il reste la couche supérieure d'oxyde 53 installée précédemment. Les flancs 63 subsistent partiellement dans les intervalles 16, 16′ avec un profil uniforme (leur contour est repéré par les lignes en tirets 64) et recouvrent les tranches conductrices des grilles, qui sont ainsi entièrement entourées d'isolant par ailleurs, l'isolant remplissant les intervalles 15, 15′ en dehors des élargissements 16, 16′ n'a pas été atteint par la gravure. On est en fait parvenu au circuit intégré représenté figures 3 à 5 à cette différence près que les lignes de connexions électriques n'ont pas été installées : les couches supérieures d'oxyde 32 et 53 des figures 3 et 13 correspondent à la même couche, de même que les flancs 33 et ceux délimités par le contour 64.

La dernière étape du procédé d'obtention consiste donc à installer ces lignes en déposant du métal (aluminium ou tungstène) de façon à combler entièrement les élargissements 16, 16′ et à recouvrir la couche d'oxyde supérieure 53. Un masque est alors installé à l'emplacement des lignes 11 et 12 que l'on souhaite réaliser et le reste du dépôt métallique est gravé par plasma jusqu'à ce qu'on parvienne de nouveau à l'oxyde. Les lignes 11 et 12 étant constituées, le masque de résine peut être retiré.

Pour obtenir le circuit intégré représenté figure 6, le procédé est analogue à ceci près que les étapes illustrées sur les figures 10 et 11 ne sont pas pratiquées : après avoir obtenu les zones isolantes 25 et éventuellement aplani le substrat 24, on forme directement par exemple par oxydation thermique du substrat une couche isolante de façon à obtenir l'oxyde de grille 57, puis la couche conductrice 52 et la couche supérieure d'oxyde 53 de la figure 12.

La description des figures se réfère à un procédé de réalisation de circuit intégré comportant des bandes isolantes 25 et éventuellement des bandes de grilles flottantes avant la réalisation des grilles de commande. Cependant, l'invention s'applique également à un procédé de réalisation de circuit intégré comportant comme dans le cas de l'art antérieur décrit, des zones isolantes qui ne sont pas sous forme de bandes associées éventuellement à une couche conductrice gravée au-dessus de ces zones pour former ultérieurement les grilles flottantes. Ce procédé permet d'éviter la gravure des zones isolantes dans les intervalles 15'. De préférence, dans l'invention ces zones isolantes sont alors de forme rectangulaire.

Par ailleurs, les techniques de dépôt et de gravure sont bien connues de l'homme du métier. De même, les matériaux indiqués à titre d'exemple ne sont pas limitatifs. Les grilles doivent simplement être réalisées en matériau conducteur et entourées d'isolant. En outre, les lignes de connexion et les grilles de commande peuvent être dans des directions perpendiculaires à celles représentées.

Enfin, les circuits intégrés peuvent présenter des topographies différentes et ne sont pas forcément des mémoires à lecture seule, électriquement programmables (EPROM) selon une application préférée, mais peuvent aussi être des mémoires à lecture seule, électriquement programmables et effaçables (EEPROM), des mémoires dynamiques à accès aléatoires (DRAM), des mémoires statiques à accès aléatoires (SRAM) ou tout autre genre de circuit intégré.

## Revendications

1. Procédé de fabrication d'un circuit intégré, comportant les étapes suivantes :
- établissement de zones isolantes (25) d'oxyde de champ sur une face supérieure d'un substrat semiconducteur (24) et de zones actives entre les zones d'oxyde de champ,
- formation d'une première couche isolante (46, 57) sur la face supérieure du substrat,
- dépôt d'une couche conductrice (52),
- dépôt d'une deuxième couche isolante (53),
- gravure d'intervalles (15) jusqu'à la première couche isolante pour délimiter des zones actives du substrat, ces intervalles présentant des élargissements (16) et séparant des bandes conductrices provenant de la couche conductrice, ces bandes conductrices de part et d'autre des intervalles présentant des rétrécissements correspondants aux élargissements (16) des intervalles (15), ces bandes formant des grilles de commande du circuit,
- création de régions de sources et de drains (31) dans les zones actives exposées,
- dépôt d'une troisième couche isolante (60) sur toute la surface du circuit de manière à emplir complètement les intervalles hors des élargissement et partiellement les élargissements,
- gravure anisotrope de la troisième couche isolante sur toute la surface du circuit et de la première couche isolante (46, 57) jusqu'à réaliser des ouvertures de contact dans les élargissements menant aux régions de sources et de drains sans compromettre le remplissage par la troisième couche isolante des intervalles hors des élargissements, et sans enlever le matériau isolant de la deuxième couche et éventuellement celui de la troisième couche couvrant encore le circuit intégré hors des ouvertures de contact,
- installation de lignes de connexions électriques comprenant des parties s'étendant dans les ouvertures de contact.

2. Procédé de fabrication d'un circuit intégré selon la revendication 1, caractérisé en ce qu'il comprend en outre les étapes suivantes avant le dépôt de la couche conductrice :
- dépôt d'une couche conductrice inférieure (45) sur la première couche isolante,
- gravure de la couche conductrice inférieure (45) pour délimiter des bandes conductrices inferieures (47) au-dessus des zones actives surmontantes les extrémités laterales des zones d'oxyde de champ (25),
- création d'une quatrième couche isolante (48, 51) au-dessus des bandes conductrices inférieures (47), la couche conductrice inférieure et la quatrième couche isolante étant ensuite gravées en même temps que l'autre couche conductrice et la deuxième couche isolante, lors de l'étape de gravure des intervalles pour former des grilles flottantes du circuit.

3. Procédé de fabrication d'un circuit intégré suivant l'une quelconque des revendications 1 ou 2, dans lequel le substrat est en silicium, caractérisé en ce que les zones isolantes (25) sont formées par oxydation thermique localisée du substrat (24) entre les zones actives du substrat, qui sont protégées par un masque (40, 41).

4. Procédé de fabrication d'un circuit intégré suivant l'une quelconque des revendications 1 à 3, caractérisé en ce qu'il comprend une étape de dopage du substrat entre les zones isolantes (25).

5. Procédé de fabrication d'un circuit intégré suivant l'une quelconque des revendications 1 à 4, caractérisé en ce que l'installation des lignes (11, 12) de connexions s'effectue par dépôt de métal, puis gravure du dépôt de métal.

6. Procédé de fabrication d'un circuit intégré suivant l'une quelconque des revendications 1 à 5, caractérisé en ce qu'il comprend une étape d'arasement des zones isolantes (25) avant la formation de la première couche isolante (46,57).

7. Procédé de fabrication d'un circuit intégré suivant l'une quelconque des revendications 1 à 6, caractérisé en ce que les zones isolantes (25) sont établies sous forme de bandes, puis gravées après la gravure des intervalles (15) jusqu'à mettre à nu des régions du substrat (24) correspondant aux implantations des sources, la première couche isolante (46, 57) étant également gravée.

8. Procédé de fabrication d'un circuit intégré suivant la revendication 2, caractérisé en ce qu'il comprend, pour créer la quatrième couche isolante intermédiaire, des étapes de dépôt d'une première sous-couche isolante (48), de gravure partielle de la première sous-couche isolante pour ne la laisser subsister que dans les zones de gravure de la couche conductrice inférieure, et de dépôt d'une seconde sous-couche isolante (51).

## Patentansprüche

1. Herstellungsverfahren eines integrierten Schaltkreises, die folgenden Schritte umfassend:
- Herstellen von isolierenden Feldoxidzonen (25) auf einer Oberseite eines Halbleitersubstrats (24) und von aktiven Zonen zwischen den Feldoxidzonen,
- Bilden einer ersten isolierenden Schicht (46, 57) auf der Oberseite des Substrats,
- Abscheiden einer leitenden Schicht (52),
- Abscheiden einer zweiten isolierenden Schicht (53),
- Ätzen von Intervallen (15) bis zur ersten isolierenden Schicht, um aktive Zonen des Substrats abzugrenzen, wobei diese Intervalle Verbreiterungen (16) aufweisen und leitende Streifen trennen, die von der leitenden Schicht stammen, diese leitenden Streifen beiderseits der Intervalle den Verbreiterungen (16) der Intervalle (15) entsprechende Einengungen aufweisen, diese Bänder Steuergates des Schaltkreises bilden,
- Erzeugung von Sources- und Drainsbereichen (31) in den exponierten aktiven Zonen,
- Abscheiden einer dritten isolierenden Schicht (60) auf der gesamten Fläche des Schaltkreises, um die Intervalle außerhalb der Verbreiterungen vollstandig aufzufüllen und die Verbreiterungen partiell,
- anisotropes Ätzen der dritten isolierenden Schicht über die gesamte Fläche des Schaltkreises und der ersten isolierenden Schicht (46, 57), bis man in den Verbreiterungen Kontaktöffnungen hergestellt hat, die zu den Sources- und Drainsbereichen führen, ohne die Auffüllung der Intervalle durch die dritte isolierende Schicht außerhalb der Verbreiterungen zu beeinträchtigen und ohne das isolierende Material der zweiten Schicht und eventuell das der dritten Schicht zu entfernen, das den Schaltkreis außerhalb der Kontaktöffnungen noch bedeckt,
- Einrichten von elektrischen Verbindungsleitungen, die Teile umfassen, die sich in den Kontaktlöchern erstrecken.

2. Herstellungsverfahren eines integrierten Schaltkreises nach Anspruch 1, dadurch gekennzeichnet, daß es vor dem Abscheiden der leitenden Schicht außerdem folgende Schritte umfaßt:
- Abscheiden einer unteren leitenden Schicht (45) auf der ersten isolierenden Schicht,
- Ätzen der unteren leitenden Schicht (45), um über aktiven Zonen untere leitende Streifen (47) abzugrenzen, die über die seitlichen Enden der Feldoxidzonen (25) ragen,
- Erzeugen einer vierten isolierenden Schicht (48, 51) über unteren leitenden Streifen (47), wobei die untere leitende Schicht und die vierte isolierende Schicht anschließend zur gleichen Zeit geätzt werden wie die andere leitende Schicht und die zweite isolierende Schicht, beim Ätzschritt der Intervalle zum Bilden der floating bzw. schwebenden Gates des Schaltkreises.

3. Herstellungsverfahren eines integrierten Schaltkreises nach einem der Ansprüche 1 oder 2, dadurch gekennzeichnet, bei dem das Substrat aus Silicium ist, dadurch gekennzeichnet, daß die isolierenden Zonen (25) gebildet werden durch lokalisierte thermische Oxidation des Substrats (24) zwischen den aktiven Zonen des Substrats, die geschützt sind durch eine Maske (40, 41).

4. Herstellungsverfahren eines integrierten Schaltkreises nach einem der Ansprüche 1 bis 3, dadurch gekennzeichnet, daß es einen Dotierschritt des Substrats zwischen den isolierenden Zonen (25) umfaßt.

5. Herstellungsverfahren eines integrierten Schaltkreises nach einem der Ansprüche 1 bis 4, dadurch gekennzeichnet, daß die Einrichtung der Verbindungsleitungen (11, 12) durch Metallabscheidung und Ätzung der Metallabscheidung erfolgt.

6. Herstellungsverfahren eines integrierten Schaltkreises nach einem der Ansprüche 1 bis 5, dadurch gekennzeichnet, daß es einen Abgleichungsschritt der isolierenden Zonen (25) vor der Bildung der ersten isolierenden Schicht (46, 57) umfaßt.

7. Herstellungsverfahren eines integrierten Schaltkreises nach einem der Ansprüche 1 bis 6, dadurch gekennzeichnet, daß die isolierenden Zonen in Form von Bändern hergestellt werden, sodann nach dem Ätzen der Intervalle (15) geätzt werden bis zur Freilegung der Bereiche des Substrats (24), die den Implantationen der Sources entsprechen, wobei die erste isolierende Schicht (46, 57) ebenfalls geätzt wird.

8. Herstellungsverfahren eines integrierten Schaltkreises nach Anspruch 2, dadurch gekennzeichnet, daß es zum Erzeugen der vierten isolierenden Zwischenschicht Abscheidungsschritte einer ersten isolierenden Unterschicht (48) und Teilätzungsschritte der ersten isolierenden Unterschicht umfaßt, um sie nur in den Ätzzonen der unteren leitenden Schicht stehen zu lassen, und Abscheidungsschritte einer zweiten isolierenden Unterschicht (51).

## Claims

1. Method for producing an integrated circuit comprising the following stages:
- forming field oxide, insulating zones (25) on an upper face of a semiconductor substrate (24) and active zones between the field oxide zones,
- formation of a first insulating layer (46, 57) on the upper face of the substrate,
- deposition of a conductive layer (52),
- deposition of a second insulating layer (53),
- engraving gaps (15) down to the first insulating layer in order to define the active zones of the substrate and which have extensions (16) and separating conductive strips from the conductive layer, said conductive strips on either side of the gaps having retracted zones corresponding to the extension (16) of the gaps, said strips forming control gates of the circuit,
- creation of source and drain regions (31) in the exposed active zones,
- deposition of a third insulating layer (60) on the complete surface of the circuit so as to completely fill the gaps outside the extensions and in part the extensions,
- anisotropic etching of the third insulating layer over the entire surface of the circuit and the first insulating layer (46, 57) until contact openings are formed in the extensions leading to the source and drain regions and without compromising the filling by the third insulating layer of the gaps outside the extensions and without the insulating material of the second layer and optionally that of the third layer covering the integrated circuit outside the contact openings,
- installation of electrical connection lines including portions extending into the contact openings.

2. Method for producing an integrated circuit according to claim 1, characterized in that it also comprises the following stages prior to the deposition of the conductive layer:
- deposition of a lower conductive layer (45) on the first insulating layer,
- engraving the lower conductive layer (45) in order to define lower conductive strips (47) above active zones surmounting the lateral ends of the field oxide zones (25),
- creation of a fourth insulating layer (48, 51) above the lower conductive strips (47), the lower conductive layer and the fourth insulating layer then being engraved at the same time as the other conductive layer and the second insulating layer, during the stage of engraving gaps in order to form the floating gates of the circuit.

3. Method for producing an integrated circuit according to either of the claims 1 and 2, wherein the substrate is of silicon, characterized in that the insulating zones (25) are formed by localized thermal oxidation of the substrate (24) between the active zones of the substrate, which are protected by a mask (40, 41).

4. Method for producing an integrated circuit according to any one of the claims 1 to 3, characterized in that it comprises a stage of doping the substrate between the insulating zones (25).

5. Method for producing an integrated circuit according to any one of the claims 1 to 4, characterized in that the installation of the connection lines (11, 12) takes place by metal deposition, followed by the etching of the metal deposit.

6. Process for producing an integrated circuit according to any one of the claims 1 to 5, characterized in that it comprises a stage of levelling the insulating zones (25) prior to the formation of the first insulating layer (46, 57).

7. Process for producing an integrated circuit according to any one of the claims 1 to 6, characterized in that the insulating zones (25) are in the form of strips, followed by etching after the etching of the gaps (15) up to the exposure of the regions of the substrate (24) corresponding to the source implantations, the first insulating layer (46, 57) also being etched.

8. Process for producing an integrated circuit according to claim 2, characterized in that, for creating the fourth insulating, intermediate layer, it comprises stages of depositing a first insulating underlayer (48), partial etching of the insulating underlayer so as to only allow it to remain in the etching zones of the lower conductive layer and the deposition of a second insulating underlayer (51).
